Europäisches Patentamt

European Patent Office

Office européen des brevets

(19)

(11) Veröffentlichungsnummer: **0 031 139**
**B1**

(12) **EUROPÄISCHE PATENTSCHRIFT**

(45) Veröffentlichungstag der Patentschrift: **07.05.86**

(21) Anmeldenummer: **80107992.2**

(22) Anmeldetag: **17.12.80**

(51) Int. Cl.⁴: **H 03 K 4/00,** H 03 K 5/01,
G 01 R 31/28

(54) Impulsformer.

(30) Priorität: **21.12.79 DE 2951930**

(43) Veröffentlichungstag der Anmeldung:
**01.07.81 Patentblatt 81/26**

(45) Bekanntmachung des Hinweises auf die
Patenterteilung:
**07.05.86 Patentblatt 86/19**

(84) Benannte Vertragsstaaten:
**FR GB NL**

(56) Entgegenhaltungen:
**DE-B-1 933 184**

**RADIO FERNSEHEN ELEKTRONIK, Band 25, Nr.
2, 1976, P. JACOB et al. "Universeller
Impulsgenerator"**

(73) Patentinhaber: **Siemens Aktiengesellschaft
Berlin und München Wittelsbacherplatz 2
D-8000 München 2 (DE)**

(72) Erfinder: **Welzhofer, Klaus
Ruffini-Allee 30
D-8032 Gräfelfing (DE)**

Courier Press, Leamington Spa, England.

**Beschreibung**

Die Erfindung bezieht sich auf einen Impulsformer, der zur Impulsformung einen periodisch umladbaren Kondensator besitzt, bei dem zwei zueinander symmetrische, mit veränderbaren Stromquellen versehene, der periodischen Auf- und Entladung dienende Kreise vorgesehen sind, und bei dem jedem Kreis Mittel zur Spannungsbegrenzung, die den gewünschten Hub erzeugen, zugeordnet sind, deren Vorspannungsquellen abhängig von dem einzustellenden Hub veränderbar sind. Hierbei wird unter Hub die Differenzspannung zwischen der Amplitude eine Impules und einer Impulsgrundspannung verstanden.

Bei der Funktionsprüfung elektronischer Baugruppen müssen die Prüflinge mit unterschiedlichen bzw. variablen Impulsen angesteuert werden. Deshalb ist es notwendig, in den entsprechenden Prüfautomaten Impulsformer einzubauen, deren Ausgangsimpulse den geforderten individuellen Prüfbedingungen möglischst praxisnah und programmierbar angepaßt werden können.

In der DE—B2—19 33 184 und in "radio fernsehen elektronik" 25 ((1976), H.2, S-45—48 ist ein Impulsgenerator zur Erzeugung von Impulsen mit veränderbarer Flankensteilheit beschrieben, bei dem ein Kondensator zur Impulsbindung auf- und entladen wird. Zur Auf- bzw. Entladung des Kondensators sind zwei veränderbare Stromquellen vorgesehen, die die Anstiegs- bzw. Abfallzeit der Impulsflanken der zu bildenden Impulse bestimmen. Außerdem sind Spannungsbegrenzer vorgesehen, die den gewünschten Hub erzeugen.

Aufgabe der vorliegenden Erfindung ist es aber, einen Impulsformer zur Erzeugung von vorprogrammierbaren Impulsen zu schaffen, deren Parameter frei wählbar und rückwirkungsfrei zueinander einstellbar sind.

Diese Aufgabe wird bei einem Impulsformer der eingangs genannten Art durch die im Kennzeichen des Patentanspruchs 1 angegebenen Schaltungsmaßnahmen gelöst.

Durch diese Maßnahmen erhält man einen Impulsformer, bei dem die erzeugten Impulse sowohl in ihrer Grundspannung als auch in ihrem Hub und in ihren Anstiegs- und Abfallzeiten bezüglich der Vorder- und Rückflanken individuell und rückwirkungsfrei beliebig einstellbar sind.

Weiterhin ist es vorteilhaft, daß die binär gestaffelten Widerstände durch Digital-Analog-Umsetzer, die die über einen Datenbus und Speicher eingegebenen Datenparameter für den zeitlichen Anstieg und Abfall der Impulsflanken verwerten, realisiert sind, und daß die Hub- und Impulsgrundspannung, die ebenfalls über Busleitungen je einem über einen Speicher angesteuerten Digital-Analog-Umsetzer zugeführt sind, ausgangsseitig mit ohmschen Widerständen belastet sind, an denen den Ausgangsströmen proportionale Spannungen anfallen, die jeweils als Steuerspannungen für die nicht invertierenden Eingänge zweier zweiter Operationsverstärker dienen.

Die Erfindung kann ferner derart ausgebildet sein, daß der den Digital-Analog-Umsetzer für die Hubspannung zugeordnete Operationsverstärker zusammen mit einem nachgeschalteten Transistor eine Stromquelle bildet und daß zwischen dem Ausgang dieser Stromquelle und dem Ausgang des dem Digital-Analog-Umsetzer für die Impulsgrundspannung nachgeschalteten Operationsverstärker ein ohmscher Widerstand geschaltet ist. Dadurch wird erreicht, daß die programmierte Hubspannung relativ zur Grundspannungseinstellung immer konstant bleibt.

Andere Weiterbildungen der Erfindung ergeben sich aus den Unteransprüchen.

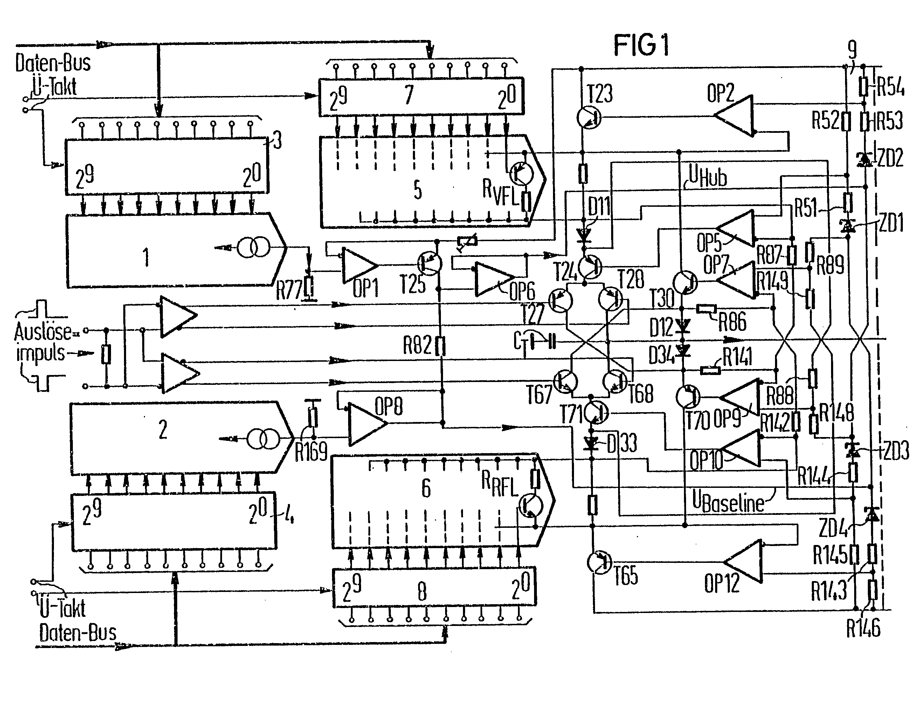

Anhand der Ausführungsbeispiele nach den Fig. 1 bis 3 wird die Erfindung näher erläutert: Es zeigen:

Fig. 1 ein vereinfachtes Blockschaltbild des Impulsformers,

Fig. 2 ein vollständiges Blockschaltbild des Impulsformers,

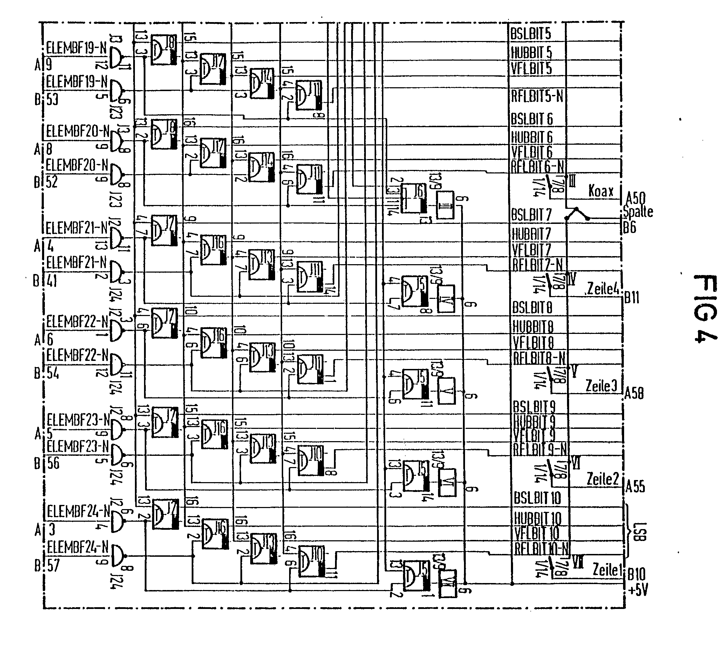

Fig. 3 und 4 den Logikteil für den Impulsformer.

Die Spannung im Diagonalzweig einer Wheatstone-Brücke wird über Operationsverstärker OP12/OP10 bzw. OP5/OP2 abgegriffen, wobei der Operationsverstärker OP12 zusammen mit dem Transistor T65 und der Operationsverstärker OP2 zusammen mit dem Transistor T23 jeweils eine Konstantspannungsquelle bildet, der Operationsverstärker OP10 mit dem Transistor T71 und der Operationsverstärker OP5 mit Transistor T24 über die Widerstände der Digital-Analog-Umsetzer 5, 6 für die Vorder- und Rückflanken dagegen als Konstantstromquelle wirkt. Durch diese Maßnahmen wird erreicht, daß sich der Konstantstrom an den Kollektoren der Transistoren T24 bzw. T71 nur bezüglich der Hubspannung ändert, jedoch nicht von der Variation der Grundspannung beeinflußt wird. Dies ist voerteilhaft, denn bei Variation der Hubspannung soll sich der Flankenstrom gemäß

$$J_{FL} = \frac{U_{Hub} \cdot C_T \text{ Konstant.}}{t_{FL}} \quad t_{FL} = \text{Flankendauer}$$

proportional zur Hubspannung verhalten, wenn man eine hubunabhängige Flankendauer des Impulses erhalten will. Von den Digital-Analog-Umsetzern 5,6 wird als der Grundwert des strombestimmten Widerstands $R_{VFL}/R_{RFL}$ eingestellt, die hubabhängige Stromregelung erfolgt über die diagonalen Brückenspannungen der später noch näher erläuterten Wheatston'schen Brücke.

Die Transistoren T67/T68 und T27/T28 bilden zwei Differenzstromschalter, die jeweils emitterseitig über de Transistoren T71 bzw. T24 mit dem hubabhängigen Konstantstrom versorgt werden.

0 031 139

Die Transistoren T68 und T28 werden über den Auslöseimpuls AJ alternierend angesteuert, so daß entweder über T68 oder über T28 Strom fließt. Dieser Strom lädt nun den Kondensator $C_T$ solange auf, bis eine der zwei Amplitudenbegrenzer-Dioden D12 oder D34 leitend werden und den Strom gegen die Konstantspannungsquellen, bestehend aus den Bauteilen T70/OP9 bzw. T30/OP7 ableiten. Obige Konstantspannungsquellen werden über die Widerstände R89 und R148 direkt von der Impuls-Grundspanning bzw. Hubspannung gesteuert. Ferner wird der durch die parasitäre Durchlaßspannung der Begrenzerdioden D12 und D34 verursachte Fehler der Amplitudenbegrenzerspannung über die Dioden D33 und D11 erfaßt und durch die Operationsverstärker OP7 bzw. OP9 kompensiert.

Dies ist deshalb möglich, weil durch die Dioden D33 und D11 letztlich derselbe Strom fließ wie durch die Begrenzerdioden D12 und D34 also bei bauartgleicher Diode auch die gleiche Durchlaßspannung auftritt. Die Transistoren T67 und T27 sorgen unter Umgehung der Dioden D12 und D34 dafür, daß die Konstantspannungsquellen mit den Transistoren T30 bzw. T70 während der Umschaltpausen stets mit dem gleichen Strom belastet werden, wie im Begrenzungsfall. Es werden dadurch unliebsame Spannungseinbrüche bei Lastsprüngen aufgrund des endlichen Innenwiderstands an den Konstantspannungsquellen mit den Transistoren T30 und T70 weitgehends vermieden.

Am Kondensator $C_T$ liegt nun das in seinen Impulsparametern fertig aufbereitete Impulsformersignal, wie es zum Eingang Endstufe gelangt.

Die Endstufe stellt z.B. einen bipolaren Spannungsfolger mit dem Spannungs-Übersetzungsverhältnis 1:1 dar.

Sie wirkt als Impedanzkonverter.

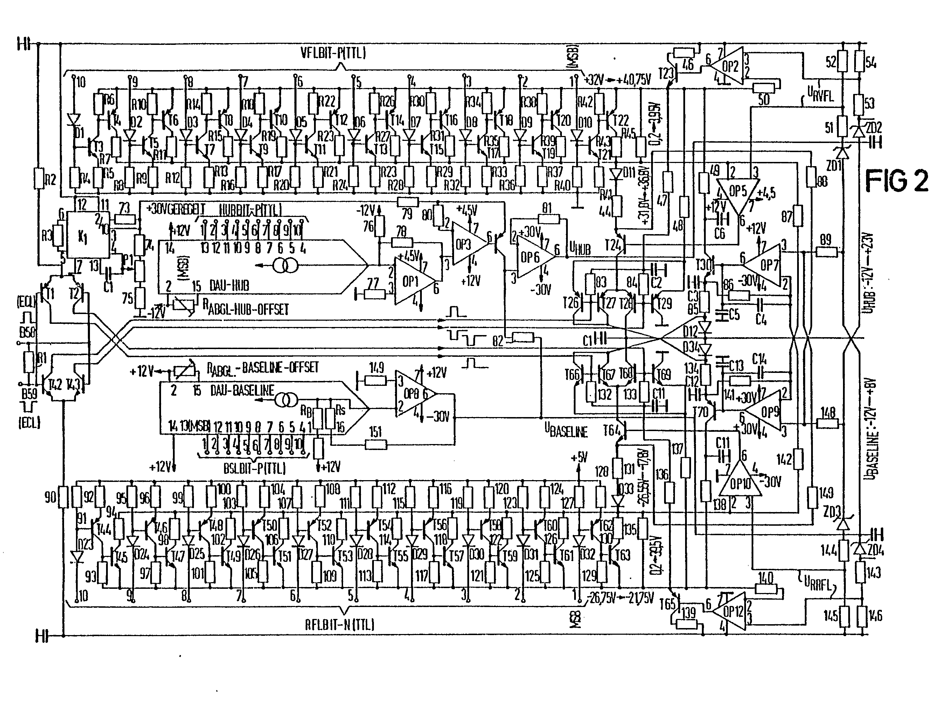

Wird der Auslöseimpuls umgepolt, dann gilt (nach Fig. 2) wenn B58 ECL '1' und B59 ECL '0'

$$J_c T_1 = \frac{+45 + |ECL\ '0'| - |U_{BE}T_1|}{R_2} \left(1 - \frac{1}{B_{T_1}}\right)$$

$$B_{T_1} = \text{Stromverstärkung } T_1$$

$$J_c T_2 = 0$$

$$J_c T_{43} = \frac{-30 + |ECL\ '1'| + |U_{BE}T_{43}|}{R_{90}} \left(1 - \frac{1}{B_{T_{43}}}\right)$$

$$B_{T_{43}} = \text{Stromverstärkung } T_{43}$$

$$J_c T_{42} = 0$$

Obige Kollektorströme liefern über den Spannungsabfall an den Widerständen $R_{83}/R_{84}$ bzw. $R_{132}/R_{133}$ das Differenzansteuersignal für die Halbleiter $T_{26}$, $T_{27}$, $T_{28}$, $T_{29}$ bzw. $T_{66}$, $T_{67}$, $T_{68}$, $T_{69}$. Der Spannungsabfall an den Widerständen $R_{47}$ und $R_{136}$ bildet den DC-Offset.

Es gilt:

$$U_B T_{26}/U_B T_{27} = U_E T_{23} - |J_c T_{42}\ (R_{47} + R_{83})|$$

$$U_B T_{28}/U_B T_{29} = U_E T_{23} - |J_c T_{43}\ (R_{47} + R_{84})|$$

$$U_B T_{66}/U_B T_{67} = U_E T_{65} + |J_c T_1\ (R_{136} + R_{132})|$$

$$U_B T_{68}/U_B T_{69} = U_E T_{65} + |J_c T_2\ (R_{136} + R_{133})|$$

$U_B$ = Transistor-Basisspannung
$U_E$ = Transistor-Emitterspannung

Die Transistoren $T_{26}$ und $T_{29}$ bzw. $T_{66}$ und $T_{69}$ bilden zueinander jeweils einen Differenzstromschalter, dessen Kollektorstrom bestimmt ist, durch:

$$J_c T_{26} = \frac{U_E T_{23} - |U_B T_{26}| - |U_B T_{26}|}{R_{48}} \left(1 - \frac{1}{B_{T_{26}}}\right)$$

$$J_c T_{66} = \frac{-U_E T_{65} + |U_B T_{66}| + |U_{BE} T_{66}|}{R_{13}} \left(1 - \frac{1}{B_{T_{66}}}\right)$$

Die Kollektorströme der Transistoren $T_{26}$ und $T_{66}$ verursachen an den Widerständen $R_{85}$ und $R_{134}$ den Spannungsabfall

$U_{R85} = J_c T_{66} \cdot R_{85}$ bzw.
$U_{R134} = J_c T_{27} \cdot R_{134}$

3

der dazu dient, an den Dioden $D_{12}$ und $D_{34}$ im Umschaltfall eine zusätzliche dynamische Sperrspannung (Addition der Kollektorströme der Transistoren $T_{26}/T_{27}$ bzw. $T_{66}/T_{67}$ zu erzeugen.

Würde diese Maßnahme nicht getroffen, so würde die im Begrenzungsfall jeweils gesättigte leitende Begrenzerdiode $D_{12}$ oder $D_{34}$, bei langsamen Flankenanstiegszeiten ($\Delta$ kleine Umladeströme für Kondensator $C_T$) den Kondensator $C_T$ im ersten Moment beim Umschalten schneller entladen, als es durch den programmierten Umladestrom gewünscht ist, was zu einer unlinearen Flankenform führen würde.

Die Halbleiterkombination $T_{27}/T_{28}$ und $T_{67}/T_{68}$ ist jeweils mit den Transistoren $T_{24}$ und $T_{71}$ zu einer Kaskadestufe zusammengeschaltet, so daß sich die Kollektorspannung ergibt:

$$U_c T_{24} = U_B T_{27} + |U_{BE} T_{27}| \text{ oder } U_B T_{28} + |U_{BE} T_{28}|$$

$$U_c T_{64} = U_B T_{67} - |U_{BE} T_{67}| \text{ oder } U_B T_{68} - |U_{BE} T_{68}|$$

Die Halbleiter $T_{24}$ und $T_{71}$ bilden jeweils Konstantstromquellen, deren Kollektorströme bestimmt sind durch:

$$J_c T_{24} = \frac{|U_{OP2}3| - |U_{OP5}3|}{R_{45} \| R_{VFL}} \left( 1 - \frac{1}{B_{T_{24}}} \right)$$

Dabei ist:
$B_{T_{24}}$ = Stromverstärkung $T_{24}$
$U_{OP2}3$ = Eingangsspannung am Operationsverstärker OP2 Pin 3
$U_{OP5}3$ = Eingangsspannung am Operationsverstärker OP5 Pin 3
$R_{VFL}$ = Programmierter Widerstand des Digital-Analog-Umsetzers 5
$R_{45} \| R_{VFL}$ = Parallelschaltung von $R_{45}$ und $R_{VFL}$

$$J_c T_{71} = \frac{|U_{OP12}3| - |U_{OP10}3|}{R_{135} \| R_{RFL}} \left( 1 - \frac{1}{B_{T_{64}}} \right)$$

Dabei ist:
$B_{T_{64}}$ = Stromverstärkung $T_{64}$
$U_{OP12}8$ = Eingangsspannung am Operationsverstärker OP12 Pin 3
$U_{OP10}3$ = Eingangsspannung am Operationsverstärker OP10 Pin 3
$R_{RFL}$ = Programmierter Widerstand des Digital-Analog-Umsetzters 6
$R_{135} \| R_{RFL}$ = Parallelschaltung von $R_{135}$ und $R_{RFL}$.

In obigen Formeln werden die Differenzspannungen $U_{OP2}3 - U_{OP5}3$ bzw. $U_{OP12}3 - U_{OP10}3$ jeweils hubabhängig automatisch nachgeführt, wogegen die programmierbaren Widerstände $R_{VFL}$ und $R_{RFL}$ als quasi statische Grundwerte vom Programm extern voreingestellt werden müssen.

Durch diese Nachregelung ist gewährleistet, daß sich gemäß

$$t_{FL} = \frac{U_{HUB} \cdot C_T}{J_{FL}}$$

$t_{FL}$ = Flankendauer
$J_{FL}$ = Flankenstrom
der Flankenstrom im gleichen Verhältnis relativ zur Hubspannung ändert.

Wie bereits erwähnt, wirken die Ausgänge des Digital-Analog-Umsetzers 5, 6 für die Vorderflanken- bzw. Rückflankenprogrammierung als Widerstände. Da die Programmierung über 10 Bit erfolgt, beinhaltet jeder Digital-Analog-Umsetzer, kurz DAU, 10 binär gestaffelte Widerstandswerte:

DAU 5: $R_7/R_{11}/R_{15}/R_{19}/R_{23}/R_{27}/R_{31}/R_{35}/R_{39}/R_{43}$
DAU 6: $R_{94}/R_{98}/R_{102}/R_{106}/R_{110}/R_{114}/R_{118}/R_{122}/R_{126}/R_{130}$
die durch die Transistoren:
DAU 5: $T_4/T_6/T_8/T_{10}/T_{12}/T_{14}/T_{16}/T_{18}/T_{20}/T_{22}$
DAU 6: $T_{45}/T_{47}/T_{40}/T_{51}/T_{53}/T_{55}/T_{57}/T_{59}/T_{61}/T_{63}$
eingeschaltet werden.

Ferner muß jeder der beiden Digital-Analog-Umsetzer wegen der Nachregelung schwimmend aufgebaut sein.

Dies geschieht durch die Halbleiter:
DAU 5: $T_3/T_6/T_7/T_9/T_{11}/T_{13}/T_{17}/T_{19}/T_{21}$
DAU 6: $T_{44}/T_{40}/T_{48}/T_{50}/T_{52}/T_{54}/T_{56}/T_{58}/T_{60}/T_{62}$

die jeweils als Stromquellenschalter arbeiten, und somit den OV-bezogenen Eingangspegel der TTL-Ansteuerlogik in einem Stromhub konstanter Größe umformen, mit z.B.

$$J_c T_3 = \frac{|U_{TTL} \, '1'| - |U_{D1}| - |U_{BE}T_3|}{R_5} \left( 1 - \frac{1}{B_{T_3}} \right)$$

Dieser Strom dient als Basisstrom für Transistor $T_4$, so daß der Transistor $T_4$ gesättigt wird und bis zur $U_{CE}$-Restspannung durchschaltet. Die Widerstände $R_4$ und $R_6$ räumen im Sperrfall die Basisladungen aus, indem sie die Basen der Transistoren $T_3$ und $T_4$ auf Emitterpotential binden.

Die Pegelumsetzer der restlichen Digital-Analog-Umsetzer-Bits arbeiten sinngemäß. Die Digital-Analog-Umsetzer für die Grundspannung 2 und für die Hubspannung 1 besitzen einen Stromquellen-Ausgang, dessen Ausgangsströme binär gewichtet sind. Da die Stromquellen-Ausgänge einerseits gegen 0 Volt belastet werden müssen, andererseits die Ströme in Spannungen mit dem erforderlichen DC-Offset umgesetzt werden müssen, war es nötig, die Operationsverstärker $OP_1$ bzw. $OP_8$ einzufügen, deren Ausgangsspannung sich verhält wie:

$$U_{AOP}1 = J_{ADAU} \cdot R_{78} + \frac{12 \cdot R_{78}}{R_{76}}$$

$$U_{AOP}8 = J_{ADAU} \, (R_{151} + R_s) - \frac{12 \, (R_{151} + R_s)}{R_{150} + R_B}$$

Die Ausgangsspannung des Operationsverstärkers $OP_8$ kann direkt als Impuls-Grundspannung verwendet werden, da $OP_8$ gleichzeitig als Impedenzkonverter wirkt und die Ausgangsspannung deshalb ausreichend belastbar ist.

Die Ausgangsspannung von $OP_1$ dient als Steuerspannung für die Konstantstromquelle, bestehend aus den Bauteilen $OP_3$ und $T_{25}$ für dessen Ausgangsstrom gilt:

$$J_c T_{25} = \frac{|U_K 1| - |U_{OP3}3|}{R_{79}} \left( 1 - \frac{1}{B_{T_{25}}} \right)$$

Dabei ist:
$U_K 1$ = Ausgangsspannung der Konstantspannungsquelle K1
$U_{OP3}3$ = Eingangsspannung am Operationsverstärker OP3 Pin 3
$B_T 25$ = Stromverstärkung von $T_{25}$

Der Kollektorstrom des Transistors $T_{25}$ fließ durch den Widerstand $R_{82}$ der seinerseits mit der Impuls-Grundspannung verbunden ist. Die Spannung am Eingang des Operationsverstärkers OP6 ist somit, bestimmt durch:

$$U_{OP6}3 = U_{Impuls\text{-}Grundspannung} + J_c T_{25} \cdot R_{82}.$$

Der Operationsverstärker OP6 wirkt als Spannungsfolger und Impedanzkonverter; sein Ausgang erzeugt die Hubspannung.

Mittels Potentiometer P1 läßt sich die Ausgangsspannung der Konstantspannungsquelle K1 geringfügig verändern, wodurch sich eine Einstellmöglichkeit für den DC-Offset der Hubspannung relativ zur Impuls-Grundspannung ergibt. Grundspannung und Hubspannung steuern zwei Wheatston' sche Brücken, deren Diagonalspannungen sich verhalten wie:

$$U_{RVFL} = U_{HUB} + \frac{45 - |U_{HUB}| - |U_{ZD}2|}{R_{53} + R_{54}} \cdot R_{53} + |U_{ZD}2|$$

$$- (U_{BASIS} + \frac{45 - |U_{BASIS}| - |U_{ZD}1|}{R_{51} + R_{52}} \cdot R_{51} + |U_{ZD}1|)$$

$$U_{RRFL}=U_{HUB}-\frac{30-|U_{HUB}|-|U_{ZD}3|}{R_{144}+R_{145}}\cdot R_{144}-|U_{ZD}3|$$

$$-(U_{BASIS}-\frac{30-|U_{BASIS}|-|U_{ZD}4|}{R_{146}+R_{147}}\cdot R_{147}-|U_{ZD}4|)$$

Obige Spannungen dienen jeweils als Führungsspannungen für die Flanken-Stromquellen. Durch die Anordnung der Bauteile in Brückenschaltung werden die Temperaturfehler der Bauteile kompensiert, da die Führungsspannungen differentiell entstehen.

Impuls-Grundspannung und Hubspannung steuern direkt — über die Widerstände $R_{89}$ bzw. $R_{148}$ — je eine Konstantspannungsquelle, bestehend aus den Bauteilen OP7/$T_{30}$ bzw. OP9/$T_{70}$. Diese beiden Spannungsquellen erzeugen die Begrenzungsspannungen für die Amplitudenbegrenzer-Dioden $D_{12}$ und $D_{34}$. Nachdem der Begrenzerstrom entweder über $R_{85}$ und $D_{12}$, oder über $R_{134}$ und $D_{34}$ fließ, ergibt sich ein Fehler bezüglich der Begrenzungsspannungen von:

$$U_{FHubbegr.}=J_cT_{28}\cdot R_{134}+|U_D34|$$

$$U_{FBasisbegr.}=J_cT_{68}\cdot R_{85}+|U_D12|$$

Dieser Fehler wird dadurch kompensiert, daß derselbe Fehlerspannungsabfall an den Widerstands-Dioden-Kombinationen $R_{44}/D_{11}$ bzw. $R_{131}/D_{33}$ bewußt erzeugt wird (durch diese Bauteile fließt der gleiche Begrenzerstrom), und durch eine Gegenkopplung—über die Widerstände $R_{87}/R_{88}$ bzw. $R_{142}/R_{149}$—gleichphasig den Eingängen der Operationsverstärker OP9 bzw. OP7 mitgeteilt wird. Die Operationsverstärker regeln dadurch die jeweilige Begrenzerspannung um den Fehlbetrag automatisch nach. Die Kapazitäten $C_4$, $C_5$, $C_{10}$, $C_{14}$ dienen zur Frequenzkompensation; sie verhindern ein Schwingen beim Umprogrammieren der Begrenzerspannungen.

Hinter den Zenerdioden ZD2 und ZD4 werden die Führungsspannungen für die Stromversorgung der Endstufe abgegriffen.

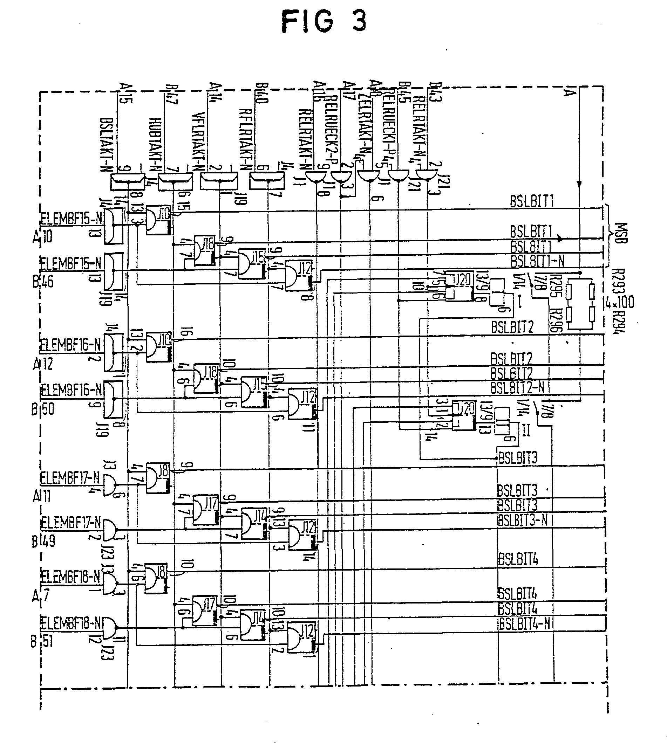

Den Digitalteil zeigt Fig. 3 Über die Eingänge $A_3$ bis $A_{12}$, $B_{41}$, $B_{46}$, $B_{49}$ bis $B_{54}$, $B_{56}$, $B_{57}$ und die Inverter-Gatter $J_2$, $J_3$, $J_4$, $J_{19}$, $J_{23}$, $J_{24}$ gelangen die Parameterdaten parallel an die Vorbereitungseingänge der D-Flipflops $J_7$, $J_8$, $J_{10}$ bis $J_{18}$.

Ein Übernahmetakt (an den Eingängen $A_{14}$, $A_{15}$, $B_{47}$, $B_{48}$) steuert nun über einen Leistungsinverter jeweils 10 parallelgeschaltete Takteingänge obiger D-Flipflops, deren Ausgänge direkt zu den entsprechenden DAU's im Analogteil führen. Damit die Parameterdaten richtig in die Flipflops übernommen werden ist es erforderlich, daß der jeweilige Übernahmetakt nicht schmaler als 20ns wird, und die minimale Vorbereitungszeit der Parameterdaten gegenüber der negativen Flanke des Übernahmetaktes von 20ns nicht unterschritten wird.

Die Umschaltung des Augangswiderstandes erfolgt durch Relais I über Flipflop $J_{20}$. Bei gleichzeitigem Aktivieren von ELEMBF21-N und RELRTAKT-N wird das Flipflops 20 gesetzt, was den Ausgangswiderstand $\leq 3\Omega$ bewirkt. Bei gleichzeitigem Aktivieren von ELEMBF22-N und RELRTAKT-N wird das Flipflop $J_{20}$ rückgesetzt, wodurch der Ausgangswiderstand 100 $\Omega$ eingeschaltet wird.

Mit Relais II über Flipflop $J_{20}$ wird der Impulsformerausgang grundsätzliche an- oder abgeschaltet. Hierfür muß entweder ELEMBF-N und RELRTAKT-N aktiviert werden, was Impulsformerausgang anschalten bedeutet oder ELEMBF24-N und RELRTAKT-N aktiviert werden, was Impulsformerausgang abschalten bedeutet.

Durch das Rücksetzignal RELRUECK1-P werden beide Flipflops $J_{20}$ programmierungsunabhängig rückgesetzt, d.h. Impulsformerausgangswiderstand $\underline{\Delta}$ 100 $\Omega$ und Impulsformerausgang abgeschaltet.

Mittels der Relais III, IV, V, VI und VII wird der Ausgangsimpuls auf fünf voneinander unabhängige Ausgangs-Pins $A_{50}$, $B_{11}$, $A_{58}$, $A_{55}$ und $B_{10}$ verteilt. Obige Relais werden durch die Flipflops $J_5$ und $J_6$ gesteuert, wobei die Flipflops $J_5$ (D-Flipflop) durch den Übernahmetakt ZELRTAKT-N die Information von ELEMBF-21N bis ELEMBF-24N übernehmen, Flipflop $J_6$ dagegen durch ELEMBF19-N bzw. ELEMBF20-N in Koinzidenz zum RELRTAKT-N gesetzt bzw. rückgesetzt wird. Flipflop $J_6$ kann ferner über RELRUECK2-P auch noch programmierungsunabhängig rückgesetzt werden.

**Patentansprüche**

1. Impulsformer, der zur Impulsformung einen periodisch umladbaren Kondensator besitzt, bei dem zwei zueinander symmetrische, mit veränderbaren Stromquellen versehene, der periodischen Auf- und Entladung dienende Kreise vorgesehen sind, und bei dem jedem Kreis Mittel zur Spannungsbegrenzung, die den gewünschten Hub erzeugen, zugeordnet sind, deren Vorspannungsquellen abhängig von dem einzustellenden Hub veränderbar sind, gekennzeichnet durch folgende Merkmale:

a) der erste Kreis enthält zusatzlich zu einer ersten Stromquelle (OP5, T24) binär gestaffelte zuschaltbare Widerstände (RVFL) zur Einstellung der Anstiegzeit der Impulsflanken der zu bildenden Impulse, und eine erste einstellbare Spannungsquelle (OP2, T23),

b) der zweite Kreis enthält zusätzlich zu einer zweiten Stromquelle (OP10, T71) binär gestaffelte zuschaltbare Widerstände ($R_{RFL}$) zur Einstellung der Abfallzeit der Impulsflanken der zu bildenden Impulse, und eine zweite einstellbare Spannungsquelle (OP12, T65),

c) es ist eine Wheatston'sche Brücke (9) vorgesehen, deren beiden Brückenzweige aus je einem ersten (R53, R54; R51, R52) und zweiten (R144, R145; R143, R146) Spannungsteiler bestehen,

d) die einstellbare Hubspannung ($U_{Hub}$) liegt am Verbindungspunkt der beiden Spannungsteiler des einen Brückenzweiges und die einstellbare Impulsgrundspannung ($U_{BASELINE}$) am Verbindungspunkt der beiden Spannungsteiler des anderen Brückenzweiges,

e) die aus einem Operationsverstärker (OP5) und einem nachgeschalteten Transistor (T24) bestehende erste Stromquelle ist mit dem Steuereingang des Operationsverstärkers (OP5) am Abgriff des ersten Spannungsteilers (R51, R52) des anderen Brückenzweiges angeschlossen,

f) die aus einem Operationsverstärker (OP10) und einem nachgeschalteten Transistor (T71) bestehende zweite Stromquelle ist mit dem Steuereingang des Operationsverstärkers (OP10) am Abgriff des entsprechenden zweiten Spannungsteilers (R144, R145) des einen Brückenzweiges angeschlossen,

g) die erste Spannungsquelle (OP2, T23) ist mit ihrem Steuereingang mit dem Abgriff des ersten Spannungsteilers (R53, R54) des einen Brückenzweiges verbunden,

h) die zweite Spannungsquelle (OP12, T75) ist mit ihrem Steuereingang mit dem Abgriff des entsprechenden zweiten Spannungsteilers (R143, F146) des anderen Brückenzweiges verbunden,

i) zwischen der ersten und der zweiten Stromquelle (OP5, T24 und OP10, T71) ist ein Differenzschalter (T28, T68) angeordnet, der den Kondensator ($C_T$) abwechselnd an die erste oder die zweite Stromquelle anlegt.

2. Impulsformer nach Patentanspruch 1, dadurch gekennzeichnet, daß die binär gestaffelten Widerstände durch Digital-Analog-Umsetzer (5, 6), die die über einen Datenbus und Speicher (7, 8) eingegebenen Datenparameter für den zeitlichen Anstieg und Abfall der Impulsflanken verwerten, realisiert sind.

3. Impulsformer nach Patentanspruch 1, dadurch gekennzeichnet, daß die Hub- und Impulsgrundspannungsparameter ebenfalls über Busleitungen je einem über einen Speicher (3, 4) angesteuerten Digital-Analog-Umsetzer (1, 2) zugeführt sind, die ausgangsseitig mit ohmschen Widerständen (R77, R169) belastet sind, an denen den Ausgangsströmen porportionale Spannungen anfallen, die jeweils als Steuerspannungen für die nichtinvertierenden Eingänge zweier zweiter Operationsverstärker (OP1, OP8) dienen.

4. Impulsformer nach Patentanspruch 3, dadurch gekennzeichnet,

— daß der dem Digital-Analog-Umsetzer (1) für die Hubspannung zugeordnete Operationsverstärker (OP1) zusammen mit einem nachgeschalteten Transistor (T25) eine Stromquelle bildet und
— daß zwischen dem Ausgang dieser Stromquelle und dem Ausgang des dem Digital-Analog-Umsetzer (2) für die Impulsgrundspannung nachgeschalteten Operationsverstärkers (OP8) ein ohmscher Widerstand (R82) geschaltet ist.

5. Impulsformer nach Patentanspruch 4, dadurch gekennzeichnet, daß am Ausgang der Stromquelle (OP1, T25) der Steuereingang eines dritten Operationsverstärkers (OP6) liegt, dessen invertierender Eingang mit seinem Ausgang und dessen Ausgang, an dem die Hubspannung ($U_{Hub}$) abgegeben wird, mit dem Verbindungspunkt der beiden Spannungsteiler (R53, R54; R144, R145) des einen Brückenzweiges der Wheatstone-Brücke (9) verbunden ist, während der Ausgang des Operationsverstärkers (OP8) für die Impulsgrundspannung ($U_{BASELINE}$) an den Verbindungspunkt der beiden Spannungsteiler (R52, R51; R143, R146) des anderen Brückenzweiges der Wheatstone-Brücke (9) geführt ist.

6. Impulsformer nach einem der vorhergehenden Ansprüche, dadurch gekennzeichnet, daß die Spannungsquellen (OP2, T23; OP12, T65) Emitterfolger sind, die durch vierte Operationsverstärker (OP2, OP12) mit einem jeweils nachgeschalteten Transistor (T23, T65) gebildet sind.

7. Impulsformer nach Patentanspruch 6, dadurch gekennzeichnet,

— daß die Mittel zur Spannungsbegrenzung Zenerdioden (D12, D34) sind,
— daß deren Spannungsquellen ebenfalls Emitterfolger darstellende fünfte Operationsverstärker (OP7, OP9) mit nachgeschalteten Transistoren (T30, T70) sind,
— daß der Steuereingang des ersten fünften Operationsverstärkers (OP7) an dem Abgriff eines Spannungsteilers (R149, R89) liegt, der zwischen dem Emitter des Transistors (T71) der zweiten Stromquelle (OP10, T71) und dem Verbindungspunkt der Spannungsteiler des anderen Brückenzweiges der Wheatstone-Brücke (9) liegt, und
— daß der Steuereingang des zweiten fünften Operationsverstärkers (OP9) an dem Abgriff eines Spannungsteilers (R88, R148) liegt, der zwischen dem Emitter des Transistors (T24) der ersten Stromquelle (OP5, T24) und dem Verbindungspunkt der Spannungsteiler des einen Brückenzweiges der Wheatstone-Brücke (9) liegt.

8. Impulsformer nach einem der vorhergehenden Patentansprüche, dadurch gekennzeichnet,

— daß die beiden einen Differenzschalter bildenden Transistoren (T27, T28, T67, T68) jeweils vom gleichen, jedoch auf die Schalter bezogen komplementären Leitfähigkeitstyp sind,
— daß die Kollektoren je eines Transistors (T28, T68) jedes Schalters und die Emitter der beiden zu einem Schalter gehörenden Transistoren (T27, T28, T67, T68) miteinander verbunden sind, und
— daß die Kollektoren der noch verbleibenden Transistoren (T27, T67) unter Umgehung der Mittel zur Spannungsbegrenzung (D12, D34) direkt mit deren Vorspannungsquellen (T30, OP7, T70, OP9) verbunden sind.

9. Impulsformer nach Patentanspruch 3, dadurch gekennzeichnet, daß die den Digital-Analog-Umsetzern (1, 2, 5, 6) vorgeschalteten Speicher (3, 4, 7, 8) Flipflop-Speicher sind.

**Revendications**

1. Formateur d'impulsions, qui possède un condensateur, dont la charge peut être modifiée périodiquement, pour la formation des impulsions, et dans lequel il est prévu deux circuits réciproquement symétriques, comportant des sources de courant variables et servant à réaliser une charge et une décharge périodiques, et dans lequel à chaque circuit sont associés des moyens servant à limiter la tension et qui produisent une excursion désirée et dont les sources de tension de polarisation peuvent être modifiées en fonction de l'excursion devant être réglée, remarquable par les caractéristiques suivantes:
a) le premier circuit contient, en plus d'une première source de courant (OP5, T24), des résistances (RVFL) aptes à être branchées en supplément et égagées selon un mode binaire et servant à régler le temps de montée des flancs des impulsions devant être formées, et une première source de tension réglable (OP2, T23),
b) le second circuit contient, en plus d'une seconde source de courant (OP10, T71), des résistances ($R_{RFL}$) pouvant être branchées en supplément et étagées selon un mode binaire et servant à régler le temps de retombée des flancs des impulsions devant être formées, et une seconde source de tension réglable (OP12, T65),
c) il est prévu un pont de Wheatstone (9), dont les deux branches sont constituées par respectivement un premier diviseur de tension (R53, R54; R51, R52) et un second diviseur de tension (R144, R145; R143, R146),
d) la tension réglable d'excursion ($U_{excursion}$) est présente au niveau du point de jonction des deux diviseurs de tension d'une première branche du pont et la tension de base impulsionnelle réglable ($U_{BASELINE}$) est présente au niveau du point de jonction des deux diviseurs de tension de la seconde branche du pont,
e) la première source courant, qui est constituée par un amplificateur opérationnel (OP5) et par un transistor (T24) branché en aval, est raccordée, par l'entrée de commande de l'amplificateur opérationnel (OP5), à la prise du premier diviseur de tension (R51, R52) de la seconde branche du pont,
f) la seconde source de courant, qui est constituée par un amplificateur opérationnel (OP10) et par un transistor (T71) branché en aval, est raccordée, par l'entrée de commande de l'amplificateur opérationnel (OP10), à la prise du second diviseur de tension correspondant (R144, R145) de la première branche du pont,
g) la première source de tension (OP2, T23) est reliée, par son entrée de commande, à la prise du premier diviseur de tension (R53, R54) de la première branche du pont,
h) la seconde source de tension (OP12, T65) est reliée, par son entrée de commande, à la prise du second diviseur de tension correspondant (R53, R56) de la seconde branche du pont, et
i) entre les première et seconde sources de courant (OP5, T24 et OP10, T71) se trouve disposé un commutateur différentiel (T28, T68), qui raccorde en alternance le condensateur ($C_T$) à la première ou à la seconde source de courant.
2. Formateur d'impulsions suivant la revendication 1, caractérisé par le fait que des résistances échelonnées en mode binaire sont réalisées par des convertisseurs numérique/analogique (5, 6), qui évaluent les paramètres de données, introduits par l'intermédiaire d'un bus de transmission de données et d'une mémoire (7, 8), pour la montée et la retombée dans le temps des flancs des impulsions.
3. Formateur d'impulsions suivant la revendication 1, caractérisé par le fait que les paramètres de base de l'excursion et des impulsions sont également envoyés par l'intermédiaire de bus de transmission à des convertisseurs numérique/analogique respectifs (1, 2), commandés par l'intermédiaire d'une mémoire (3, 4) et qui sont chargés, sur leur sortie, par des résistances ohmiques (R77, R169) dans lesquelles chutent des tensions qui sont proportionnelles aux courants de sortie et qui servent respectivement de tensions de commande pour les entrées non inverseuses de deux seconds amplificateurs opérationnels (OP1, OP8).
4. Formateur d'impulsions suivant la revendication 3, caractérisé par le fait:

— que l'amplificateur opérationnel (OP1), qui est associé au convertisseur numérique/analogique (1) pour la tension d'excursion, forme, en association avec un transistor (T25) branché en aval, une source de courant, et

— qu'une résistance ohmique (R82) est branchée entre la sortie de cette source de courant et la sortie de l'amplificateur opérationnel (OP8) branché en aval du convertisseur numérique/analogique (2) pour la tension de base des impulsions.

5. Formateur d'impulsions suivant la revendication 4, caractérisé par le fait qui'à la sortie de la source de courant (OP1, T25) se trouve raccordée l'entrée de commande d'un troisième amplificateur opérationnel (OP6), dont l'entrée inverseuse est reliée à la sortie de cet amplificateur et dont la sortie, sur laquelle la tension d'excursion ($U_{excursion}$) est délivrée, est reliée au point de jonction des deux diviseurs de tension (R53, R54; R144, R145) de la première branche du pont de Wheatstone (9) tandis que la sortie de l'amplificateur opérationnel (OP8) pour l'obtention de base des impulsions ($U_{BASELINE}$) est reliée au point de jonction des deux diviseurs de tension (R52, R51, R53, R56) de la seconde branche du pont de Wheatstone (9).

6. Formateur d'impulsions suivant l'une des revendications précédentes, caractérisé par le fait que les sources de tension (OP2, T23; OP12, T65) sont des montages en émetteur suiveur, qui sont formés par des quatrièmes amplificateurs opérationnels (OP2, OP12) comportant des transistors respectifs (T23, T65) branchés en aval.

7. Formateur d'impulsions suivant la revendication 6, caractérisé par le fait

— que les moyens servant à limiter la tension sont des diodes Zener (D12, D34),
— que leurs sources de tension sont des cinquièmes amplificateurs opérationnels (OP7, OP9) constituant également des montages en émetteur suiveur et en aval desquels sont branchés des transistors respectifs (T30, T70),
— que l'entrée de commande des premier et cinquième amplificateurs opérationnels (OP7) est raccordée à la prise d'un diviseur de tension (R149, R89), qui est montée entre l'émetteur du transistor (T71) de la seconde source de courant (OP10, T71) et le point de jonction des diviseurs de tension de la seconde branche du pont de Wheatstone (9), et
— que l'entrée de commande du second et cinquième amplificateurs opérationnels (OP9) est raccordée à la prise d'un diviseur de tension (R88, R148), qui est montée entre l'émetteur du transistor (T24) de la première source de courant (OP5, T24) et le point de jonction des diviseurs de tension de la première branche du pont de Wheatstone (9).

8. Formateur d'impulsions suivant l'une des revendications précédentes, caractérisé par le fait que:

— les deux transistors (T27, T28, T67, T68) constituant un commutateur différentiel possèdent des types de conductivité respectivement identiques, mais complémentaires en ce qui concerne les commutateurs,
— que les collecteurs de chaque transistor (T28, T68) de chaque commutateur et les émetteurs des deux transistors (T27, T28, T67, T68), appartenant à un commutateur, sont reliés entre eux, et
— que les commutateurs des autres transistors (T27, T67) sont reliés directement à leurs sources de tension de polarisation (T30, OP7, T70, OP9), moyennant un contournement des moyens (D12, D34) servant à limiter la tension.

9. Formateur d'impulsions suivant la revendication 3, caractérisé par le fait que les mémoires (3, 4, 7, 8), qui sont branchées en amont des commutateurs numérique/analogique (1, 2, 5, 6), sont des mémoires à bascules bistables.

**Claims**

1. A pulse shaper which has a periodically rechargeable capacitor for pulse-shaping, wherein two mutually symmetrical circuits provided with variable current sources serve to effect a periodic charging and discharging, and wherein each circuit is assigned voltage limitation means which produce the desired shift and whose bias voltage sources can be changed in dependence upon the shift which is to be set, characterised by the following features:

a) in addition to a first current source (OP5, T24), the first circuit contains resistors (RVFL) which can be connected in binary-staggered fashion in order to set the rise time of the pulse flanks of the pulses which are to be formed, and also contains a first adjustable voltage source (OP2, T23),

b) in addition to a second current source (OP10, T71), the second circuit contains resistors ($R_{RFL}$) which can be connected in binary-staggered fashion in order to set the decay time of the pulse flanks of the pulses which are to be formed, and also contains a second adjustable voltage source (OP12, T65),

c) a Wheatstone bridge (9) is provided, the two bridge arms of which each consist of a first (R53, R54; R51, R52) voltage divider and a second (R144, R145; R143, R146) voltage divider,

d) the adjustable shift voltage ($U_{Hub}$) is connected to the connection point of the two voltage dividers of the first bridge arm, and the adjustable pulse fundamental voltage ($U_{BASELINE}$) is connected to the connection point of the two voltage dividers of the other bridge arm,

e) the first current source, which consists of an operational amplifier (OP5) and a following transistor (T24) is connected by the control input of the operational amplifier (OP5) to the tapping of the first voltage divider (R51, R52) of the other bridge arm,

f) the second current source, which consists of an operational amplifier (OP10) and a following transistor (T71) is connected by the control input of the operational amplifier (OP10) to the tapping of the corresponding second voltage divider (R144, R145) of the first bridge arm,

g) the first voltage source (OP2, T23) is connected by its control input to the tapping of the first voltage divider (R53, R54) of the first bridge arm,

h) the second voltage source (OP12, T65) is connected by its control input to the tapping of the corresponding second voltage divider (R143, F146) of the other bridge arm,

i) between the first and second current sources (OP5, T24 and OP10, T71) there is arranged a difference switch (T28, T68) which connects the capacitor ($C_T$) alternately to the first or the second current source.

2. A pulse shaper as claimed in Claim 1, characterised in that the binary-staggered resistors consist of digital-analogue converters (5, 6) which utilise the data parameters fed in from a data bus and stores (7, 8), for the time of the rise and decay of the pulse flanks.

3. A pulse shaper as claimed in Claim 1, characterised in that the shift and pulse fundamental voltage parameters are each fed via bus lines to a digital-analogue converter (1, 2) driven via stores (3, 4) and loaded at their output end by resistors (R77, R169) across which occur voltages proportional to the output currents which each serve as control voltages for the non-inverting inputs of two second operational amplifiers (OP1, OP8).

4. A pulse shaper as claimed in Claim 3, characterised in that

— together with a following transistor (T25), the operational amplifier (OP1) which is assigned to the digital-analogue converter (1) for the shift voltage forms a current source and
— that a resistor (R82) is connected between the output of this current source and the output of the operational amplifier (OP8) connected to the output end of the digital-analogue converter (2) for the pulse fundamental voltage.

5. A pulse shaper as claimed in Claim 4, characterised in that the output of the current source (OP1, T25) is connected to the control input of a third operational amplifier (OP6) whose inverting input is connected to its output, at which the shift voltage ($U_{Hub}$) is emitted, and which is connected to the connection point of the two voltage dividers (R53, R54; R144, R145) of the first bridge arm of the Wheatstone bridge (9), whereas the output of the operational amplifier (OP8) for the pulse fundamental voltage ($U_{BASELINE}$) leads to the connection point of the two voltage dividers (R52, R51; R143, R146) of the other bridge arm of the Wheatstone bridge (9).

6. A pulse shaper as claimed in one of the preceding claims, characterised in that the voltage sources (OP2, T23; OP12, T65) are emitter-followers which are formed by fourth operational amplifiers (OP2, OP12) each followed by a transistor (T23, T65).

7. A pulse shaper as claimed in Claim 6, characterised in that

— the voltage limitation means consist of Zener diodes (D12, D34),
— the voltage sources thereof consist of fifth operational amplifiers (OP7, OP9) which likewise represent emitter-followers connected at their output to transistors (T30, T70),
— the control input of the first fifth operational amplifier (OP7) is connected to the tapping of a voltage divider (R149, R89) located between the emitter of the transistor (T71) of the second current source (OP10, T71) and the connection point of the voltage dividers of the other bridge arm of the Wheatstone bridge (9), and
— the control input of the second fifth operational amplifier (OP9) is connected to the tapping of a voltage divider (R88, R148) located between the emitter of the transistor (T24) of the first current source (OP5, T24) and the connection point of the voltage dividers of the first bridge arm of the Wheatstone bridge (9).

8. A pulse shaper as claimed in one of the preceding claims, characterised in that

— the two transistors (T27, T28, T67, T68) which form a difference switch are in each case of the same conductivity type but of complementary type to the other switch,
— the collectors of one transistor (T28, T68) of each switch and the emitters of the two transistors (T27, T28, T67, T68), assigned to a switch, are connected to one another, and
— the collectors of the remaining transistors (T27, T28) are directly connected, by-passing the voltage limitation means (D12, D34), to the bias voltage sources thereof (T30, OP7, T70, OP9).

9. A pulse shaper as claimed in Claim 3, characterised in that the stores (3, 4, 7, 8) which precede the digital-analogue converters (1, 2, 5, 6) are flip-flop stores.

10

FIG 1

0 031 139

**FIG 2**

# FIG 3

**0 031 139**

# FIG 4

4